# EUROPEAN PATENT APPLICATION

(11) **EP 4 764 031 A1**
(43) Date of publication of application: **24.06.2026**
(21) Application number: 24220565.6
(22) Date of filing: 17.12.2024
(51) Int. Cl.: C23C 28/04, C23C 14/06, C23C 14/32, C23C 28/00, C23C 30/00

(54) **A COATED CUTTING TOOL**

(71) Applicant: AB Sandvik Coromant, 811 81 Sandviken (SE)
(72) Inventor: CALAMBA KWICK, Katherine, 811 81 SANDVIKEN (SE); JOHNSON, Lars, 811 81 SANDVIKEN (SE)
(74) Representative: Sandvik

(57) **Abstract**

The invention relates to a coated cutting tool comprising a substrate body and a coating, the coating comprises a sequence of layers, in the order from the substrate body surface, being one or more metal nitride layer(s) (M), the total thickness of the one or more metal nitride layer(s) (M) is from 0.5 to 8 µm, followed by a layer of Cr₁₋ₓAlₓN, 0.75≤x≤0.85, as an uppermost layer having a thickness of from 0.1 to 2 µm, the layer of Cr₁₋ₓAlₓN is of a single phase B1 cubic structure. The invention also relates to a method of producing the coated cutting tool.

## Description

The present invention relates to a coated cutting tool comprising a substrate body and a wear resistant coating deposited on the substrate body.

### Background

Cutting tools for metal cutting, commonly consist of a substrate body having a wear resistant coating. The substrate body is typically made of cemented carbide, cermet, cubic boron nitride, ceramic, or high-speed steel, most commonly cemented carbide. The coating may be made of one layer or a combination of several layers in a sequence. A layer may also be a monolithic layer or in itself be a nano-multilayer of alternating very thin sublayers. A layer in the coating is generally deposited by means of a CVD process (chemical vapor deposition) or a PVD process (physical vapor deposition). A cutting tool in this respect generally has a rake face, a flank face and a cutting edge in between. There exist various different types of PVD processes resulting in different coating properties. Cathodic arc evaporation is one of the PVD processes most frequently used for the coating of cutting tools.

A PVD coating used in coated cutting tools commonly comprises one or more metal nitride layers which provide(s) wear resistance.

The shape and geometry of the cutting tool depends on the intended metal cutting operation. Examples of cutting tools are milling inserts, turning inserts, drills, and endmills.

Different wear processes on the tool eventually deteriorates the performance of the tool and it has to be changed to a new tool. Thus, when preparing a coated cutting tool for metal cutting, a major goal is that the tool should perform in service as long as possible, i.e., the tool life should be as long as possible.

Milling operations are demanding metal cutting operations which are intermittent in nature. The thermal and mechanical load will vary over time. The former induces thermal tensions which may lead to so-called thermal cracks in the coatings, while the latter may cause chipping in the cutting edge due to fatigue. Thus, common wear types in milling are cracking and chipping, i.e., small fragments of the cutting edge loosening from the rest of the substrate. Increasing the thermal crack resistance and edge line toughness are thus of great importance to increase tool lifetime. PVD coatings are commonly used in cutting tools for milling operations.

The use of a nanolayered PVD coating instead of a PVD coating made out of one or more monolithic layers may in some cases reduce the propagation of cracks through the coating.

There is still a need for further improvement of the tool life of a coated cutting tool, as would be provided by further increased thermal crack resistance and edge line toughness.

### Object of the invention

It is an object of the present invention to provide a coated cutting tool which has both high edge line toughness and high resistance to thermal cracks giving long tool life in metal machining, especially in milling operations.

### The invention

The present invention relates to a coated cutting tool comprising a substrate body and a coating, the coating comprises a sequence of layers, in the order from the substrate body surface, being one or more metal nitride layer(s) (M), the total thickness of the one or more metal nitride layer(s) (M) is from 0.5 to 8 µm, followed by a layer of Cr₁₋ₓAlₓN, 0.75≤x≤0.85, as an uppermost layer having a thickness of from 0.1 to 2 µm, the layer of Cr₁₋ₓAlₓN is of a single phase B1 cubic structure.

The present invention further relates to a method for producing a coated cutting tool, the coated cutting tool comprises a substrate body and a coating, the coating comprises a sequence of layers, in the order from the substrate body surface, being one or more metal nitride layer(s) (M), the total thickness of the one or more metal nitride layer(s) (M) is from 0.5 to 8 µm, followed by a layer of Cr₁₋ₓAlₓN, 0.75≤x≤0.85, as an uppermost layer having a thickness of from 0.1 to 2 µm, the layer of Cr₁₋ₓAlₓN is of a single phase B1 cubic structure,
characterised in that the method comprises the following steps of:
- providing a PVD reaction chamber,
- mounting one or more targets for making the one or more metal nitride layers (M), mounting one or more targets of a composition Cr_{1-y}Al_{y}, 0.78≤y≤0.85, and mounting cutting tool blanks in the PVD reaction chamber, then
- depositing the one or more metal nitride layers (M) by cathodic arc evaporation, followed by
- depositing the layer of Cr₁₋ₓAlₓN by cathodic arc evaporation in an N₂ atmosphere at a total pressure of from 7 to 15 Pa, a DC bias voltage of from -275 to -350 V and an evaporation current of from 75 to 200 A.

The deposition of the one or more metal nitride layers (M) by cathodic arc evaporation, referred to above, can be made using any knowledge by a skilled person to combine suitable process parameters such as bias voltage level, evaporation current level and pressure.

The one or more metal nitride layers (M) is/are in itself/themselves either a monolithic layer or a nano-multilayer of at least two different sublayers of metal nitrides which are different in their elemental composition. Both types of layers are included in the general term metal nitride layer (M). As an example, a metal nitride layer (M) being (Ti,Al,Si)N may herein be a nano-multilayer of, for example, alternating (Ti,AI)N and (Ti,Si)N sublayers. Thus, the elements Ti, Al, and Si are the metal elements present in the nano-layered metal nitride which is then a (Ti,Al,Si)N layer.

The total thickness of the one or more metal nitride layer(s) (M) is suitably from 1 to 6 µm, or from 1.5 to 4 µm.

In one embodiment, any of the one or more metal nitride layer(s) (M) is a monolithic layer. In one embodiment, the monolithic layer(s) of the one or more metal nitride layer(s) (M) belong(s) to the group of (Ti,AI)N, (Ti,Al,Si)N, (Ti,Si)N, (Ti,Al,Cr)N, (Ti,Al,Cr,Si)N, (Ti,Al,Si)N and (Ti,Al,Cr,Si)N.

In one embodiment, any of the one or more metal nitride layer(s) (M) is a nano-multilayer of at least two different sublayers of metal nitrides which are different in their elemental composition, the sublayers having each an average thickness of from 1 to 50 nm.

In one embodiment, one or more metal nitride layer(s) (M) being nano-multilayer(s) belong(s) to the group of (Ti,AI)N, (Ti,Al,Si)N, (Ti,Si)N, (Ti,Al,Cr)N, (Ti,Al,Cr,Si)N, (Ti,Al,Si)N and (Ti,Al,Cr,Si)N.

In one embodiment, the at least two different sublayers of metal nitrides in the nano-multilayer(s) belong to the group of (Ti,AI)N, (Ti,Al,Si)N, (Ti,Si)N, (Ti,Al,Cr)N, (Ti,Al,Si)N, (Ti,Al,Cr,Si)N and (AI,Cr)N.

The sublayers in the nano-multilayer(s) each suitably has an average thickness of from 1 to 30 nm, or from 2 to 20 nm, or from 3 to 10 nm.

In one embodiment, the one or more metal nitride layer(s) (M) comprises a nano-multilayer which comprises sublayers of (Ti,AI)N and (Ti,Si)N.

In one embodiment, the one or more metal nitride layer(s) (M) comprise(s) a sequence of, in the direction of moving away from the substrate body surface, a monolithic (Ti,AI)N layer and a nano-multilayer of at least two different sublayers of metal nitrides which are different in their elemental composition, the nano-multilayer being a layer of (Ti,Al,Si)N, (Ti,Al,Cr)N, (Ti,Al,Cr,Si)N, (Ti,Al,Si)N or (Ti,Al,Cr,Si)N.

In the layer of Cr₁₋ₓAlₓN, suitably 0.75≤x≤0.82.

The layer of Cr₁₋ₓAlₓN, suitably has a thickness of from 0.2 to 1 µm, or from 0.2 to 0.7 µm.

In an analysis of the presence of a single phase B1 cubic crystal structure there is always a detection limit for finding a certain crystal phase. A TEM analysis is more sensitive in the detection of very small amounts of a crystal phase than an XRD analysis.

The layer of Cr₁₋ₓAlₓN is of a single phase B1 cubic structure as determined by XRD analysis (theta-2theta scan). However, in a preferred embodiment the layer of Cr₁₋ₓAlₓN is of a single phase B1 cubic structure as determined by TEM analysis.

The total thickness of the coating is suitably from 0.6 to 10 µm, or from 1 to 8 µm.

In one embodiment, the coating comprises a sequence of layers, in the order from the substrate body surface, being one or more metal nitride layer(s) (M), the total thickness of the one or more metal nitride layer(s) (M) is from 1 to 6 µm, followed by a layer of Cr₁₋ₓAlₓN, 0.75≤x≤0.82, as an uppermost layer having a thickness of from 0.2 to 0.7 µm, the layer of Cr₁₋ₓAlₓN is of a single phase B1 cubic structure.

In one embodiment, the coating comprises a sequence of layers, in the order from the substrate body surface, being one or more metal nitride layer(s) (M), of which one metal nitride layer (M) is a monolithic layer which belong(s) to the group of (Ti,Al)N, (Ti,Al,Si)N, (Ti,Si)N, (Ti,Al,Cr)N, (Ti,Al,Cr,Si)N, (Ti,Al,Si)N and (Ti,Al,Cr,Si)N, and one metal nitride layer (M) is a nano-multilayer of at least two different sublayers of metal nitrides which are different in their elemental composition, the sublayers having each an average thickness of from 1 to 50 nm, the at least two different sublayers of metal nitrides in the nano-multilayer(s) belong to the group of (Ti,AI)N, (Ti,Al,Si)N, (Ti,Si)N, (Ti,Al,Cr)N, (Ti,Al,Si)N, (Ti,Al,Cr,Si)N and (AI,Cr)N, the total thickness of the metal nitride layer(s) (M) is from 1 to 6 µm, followed by a layer of Cr₁₋ₓAlₓN, 0.75≤x≤0.82, as an uppermost layer having a thickness of from 0.2 to 0.7 µm, the layer of Cr₁₋ₓAlₓN is of a single phase B1 cubic structure.

The substrate body is suitably of a cemented carbide, a cermet, a cubic boron nitride, a ceramic, or a high-speed steel, preferably a cemented carbide.

In a preferred embodiment, the substrate body of the coated cutting tool of the present invention is a WC-Co based cemented carbide comprising from 5 to 15 wt% Co. The substrate optionally comprises further cubic carbides or carbonitrides, as is generally known in the art.

The cutting tool is suitably a cutting insert for milling, a cutting insert for turning, a cutting insert for drilling, a drill or an endmill. In a preferred embodiment, the cutting tool is a milling insert.

The cutting tool suitably comprises a rake face and a flank face with a cutting edge in between.

The deposition of the layer of Cr₁₋ₓAlₓN is suitably made at a total pressure of from 8 to 12 Pa, preferably from 10 to 12 Pa.

The deposition of the layer of Cr₁₋ₓAlₓN is suitably made at a DC bias voltage of from -300 to -325 V.

The deposition of the layer of Cr₁₋ₓAlₓN is suitably made at an evaporation current of from 100 to 175 A.

For the targets of Cr_{1-y}Aly mounted in the PVD reaction chamber suitably 0.80≤y≤0.85.

### Methods

### Crystal structure analysis of (Cr,AI)N layer by XRD analysis:

X-ray diffraction patterns were acquired by grazing incidence mode (GIXRD) on a Bruker D8 Discover diffractometer. Cu-Kα-radiation with line focus was used for the analysis (voltage = 40 kV, current = 40 mA). The incident beam was defined by a Göbel X-ray mirror producing a parallel X-ray beam addition with a 0.6° divergence slit. The sideways divergence was controlled by a Soller slit (2.5°). For the diffracted beam path a equatorial divergence Soller slit (0.04°) in conjunction with a EIGER2 R 500K Detector set in 0D mode was used. The measurements were done in grazing incidence mode (Omega = 1°). The 2theta range was 20°-80° with a step size of 0.05° and a counting time of 5 seconds. Data analysis was made by using software EVA and TOPAS from Bruker.

### Crystal structure analysis of (Cr,AI)N layer by TEM analysis:

In the TEM analysis herein made the TEM lamella preparation was done by cutting a section of the coating in a direction perpendicular to the surface plane of the substrate body on the flank face of the coated cutting tool. The TEM lamella was lifted out from the flank face at a position of 400 µm distance from the surface plane of a rake face. Also, there was a distance of 1 mm away from nearest other flank face.

The Transmission Electron Microscopy data, which are selected area electron diffraction patterns and dark field images, were acquired by a Transmission Electron Microscope Thermo Fisher Scientific Titan G2 operated at an acceleration voltage of 300 kV.

### EDX analysis:

In order to confirm the actual elemental content of Cr and Al in a (Cr,AI)N layer the average composition was analysed by using energy-dispersive X-ray spectroscopy (EDX) for some samples. The EDX measurements were made on a cross-section of the (Cr,AI)N layer. The measurements were performed using an energy-dispersive X-ray spectrometer (Oxford Instruments X-Max 80 mm2 Silicon Drift Detector) at an accelerating voltage of 10 kV on a Supra 40 (Carl Zeiss AG) scanning electron microscope.

### Coating thickness

The thicknesses of any metal nitride layer (M), the uppermost (Cr,AI)N layer, as well as the total coating thickness is suitably made by light optical microscopy (LOM) in a cross sectional cut of the coating perpendicular to the surface plane of the substrate body.

### Nanolayer thickness

The average sublayer thicknesses in a nano-multilayer may be determined by TEM analysis. TEM lamella preparation is suitably made by cutting a section of the (Cr,AI)N layer in a direction perpendicular to the surface plane of the substrate body. For the calculation of the average sublayer thicknesses at least 50 consecutive sublayers are taken into account.

### Brief description of drawings

Figure 1 shows a schematic view of one embodiment of a cutting tool being one type of milling insert.
Figure 2 shows a schematic view of a cross section of an embodiment of the coated cutting tool of the present invention showing a substrate and a coating comprising different layers.

### Detailed description of embodiments in drawings

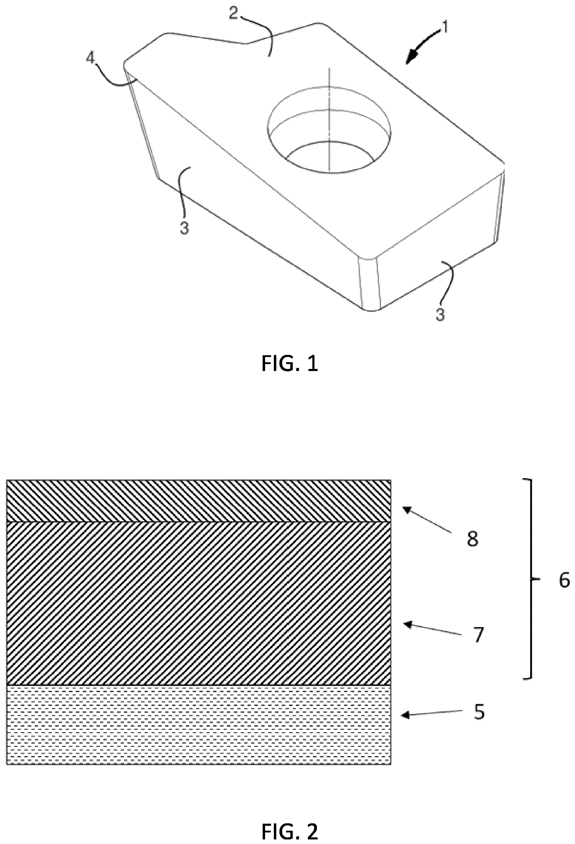

Figure 1 shows a schematic view of one embodiment of a cutting tool (1) having a rake face (2) and flank faces (3) and a cutting edge (4). The cutting tool (1) is in this embodiment a milling insert.

Figure 2 shows a schematic view of a cross section of an embodiment of the coated cutting tool of the present invention having a substrate body (5) and a coating (6). The coating comprising an inner metal nitride layer (M) (7) and an outer (Cr,AI)N layer (8).

### Examples

### Example 1: Manufacturing of single layers of (Cr,AI)N with different Al contents

Different layers of (Cr,AI)N were deposited by cathodic arc evaporation on sintered cemented carbide cutting tool insert blanks SNMA120808-KR. The cemented carbide had a composition of 10 wt% Co and rest WC. The samples 1-8 were deposited in three-fold rotation using a rotating table with "trees" of pins on which blanks were mounted. The reaction chamber comprised four flanges for targets.

Cr-Al targets were mounted on two opposing flanges with the two remaining flanges being empty. The targets were circular and planar with a diameter of 100 mm. The arc sources were the Super Fine Cathode (SFC) from Kobelco (Kobe Steel Ltd.). The target compositions used for the respecive sample are seen in Table 1. The chamber was pumped down to vacuum (less than 10⁻² Pa) and heated to about 450°C by heaters located inside the chamber. The blanks were etched for 60 minutes in an Ar plasma. The chamber pressure (reaction pressure) was set to 4 Pa, or set to 10 Pa, of N₂ gas and a desired DC bias voltage which for the samples were -70 V in combination with 4 Pa and -300 V in combination with 10 Pa, see Table 1. The cathodes were run in an arc discharge mode at a current of 150 A (each). A 3 µm layer was deposited.

**Table 1.**

| Sample | Target | Bias voltage (V) | N2 pressure (Pa) |
|---|---|---|---|
| 1 | Cr30Al70 | -70 | 4 |
| 2 | Cr25AI75 | -70 | 4 |
| 3 | Cr25AI75 | -300 | 10 |
| 4 | Cr20Al80 | -70 | 4 |
| 5 | Cr20Al80 | -300 | 10 |
| 6 | Cr15AI85 | -300 | 10 |
| 7 | Cr10AI90 | -300 | 10 |

X-ray diffraction (XRD) analysis for determining the crystal structure(s) present in a (Cr,AI)N layer was conducted on the flank face of each of the coated inserts. See Table 2 for results.

TEM analysis for determining the crystal structure(s) present in a (Cr,AI)N layer was conducted on the flank face of sample 5. See Table 2 for results.

EDX analysis of the deposited (Cr,AI)N layers was also made in order to determine the elemental composition in the deposited layers. See Table 2 for results.

**Table 2.**

| Sample | Target | Process data | Elemental composition (EDX) | Crystal structure |
|---|---|---|---|---|
| 1 | Cr30Al70 | 4 Pa, -70V | Cr31AI69N | single phase B1 cubic (XRD) |
| 2 | Cr25Al75 | 4 Pa, -70V | Cr23AI77N | cubic+hexagonal (XRD) |
| 3 | Cr25Al75 | 10 Pa, -300V | Cr28AI72N | single phase B1 cubic (XRD) |
| 4 | Cr20Al80 | 4 Pa, -70V | Cr19Al81N | single phase hexagonal (XRD) |
| 5 | Cr20Al80 | 10 Pa, -300V | Cr22AI78N | single phase B1 cubic (XRD, TEM) |
| 6 | Cr15AI85 | 10 Pa, -300V | Cr13AI87N | single phase B1 cubic (XRD) |
| 7 | Cr10Al90 | 10 Pa, -300V | Cr6Al94N | cubic + hexagonal (XRD) |

Sample 1 (Cr31Al69N by EDX) was known to be of completely cubic structure when deposited using 4 Pa/-70V.

Sample 2 (Cr23Al77N by EDX) contained both cubic and hexagonal phase found by XRD analysis when deposited using 4 Pa/ -70V.

Sample 3 used the same Cr25Al75 targets as sample 2 but in combination with process conditions 10 Pa/-300 V. The resulting elemental composition was Cr28Al72N by EDX. Only cubic phase was found by XRD analysis.

Sample 4 (Cr19Al81N by EDX) contained only hexagonal phase by XRD analysis when deposited using 4 Pa/ -70V.

Sample 5 used the same Cr20Al80 targets as sample 4 but in combination with process conditions 10 Pa/-300 V. The resulting elemental composition was Cr22Al78N by EDX. Only cubic phase was found by XRD analysis and also by TEM analysis despite the comparatively high Al content. Thus, it is concluded that the process conditions 10 Pa/-300 V promoted formation of cubic phase at a high Al content.

In sample 6 (Cr13Al87N by EDX) using process conditions 10 Pa/-300 V there was only cubic phase seen in XRD analysis.

Finally, in sample 7 (Cr6Al94N by EDX) both cubic and hexagonal phase was seen in XRD analysis.

### Example 2 - Manufacturing of coated cutting tools

Coated cutting tools were made by depositing a coating on sintered cemented carbide cutting tool insert blanks of the geometry R390-11, a milling insert. The composition of the cemented carbide was 10 wt% Co, 0.4 wt% Cr and rest WC. The coating to be deposited was a sequence of an innermost layer of (Ti,AI)N, a nano-multilayer of sublayers of (Ti,AI)N and (Ti,Si)N, and an outermost layer of (Cr,AI)N.

The cemented carbide blanks were coated by cathodic arc evaporation in a vacuum chamber comprising six arc flanges. Targets of Ti_{0.40}Al_{0.60} were mounted in two of the flanges opposite each other. Targets of Ti_{0.80}Si_{0.20} were mounted in another pair of flanges opposite each other and targets of Cr-Al were mounted in the two remaining flanges opposite each other. The targets were circular and planar with a diameter of 100 mm. The arc sources were the Super Fine Cathode (SFC) from Kobelco (Kobe Steel Ltd.).

The uncoated blanks were mounted on pins that undergo a three-fold rotation in the PVD chamber.

The chamber was pumped down to high vacuum (less than 10⁻² Pa) and heated to 450-550°C by heaters located inside the chamber. The blanks were then etched for 60 minutes in an Ar plasma.

Then, an innermost, about 0.8 µm thick, layer of Ti_{0.40}Al_{0.80}N was deposited (assuming target composition of Ti-AI in deposited nitride). The process conditions when depositing this innermost (Ti,AI)N layer were: a chamber pressure (reaction pressure) of 4 Pa of N₂ gas, and a DC bias voltage of -70 V (relative to the chamber walls) applied to the blank assembly. The cathodes were run in an arc discharge mode at a current of 150 A (each).

Then, a nano-multilayer of (Ti,Si)N and (Ti,AI)N was deposited on the (Ti,AI)N layer.

The chamber pressure (reaction pressure) was set to 4 Pa of N₂ gas, and a DC bias voltage of -70 V (relative to the chamber walls) was applied to the blank assembly. The cathodes were run in an arc discharge mode at a current of 150 A (each) for 75 minutes (4 flanges). A nano-multilayer having a thickness of about 1.2 µm was deposited on the blanks.

The table rotational speed in the PVD chamber correlates to a certain period thickness. In the deposition of the nano-multilayer a table rotational speed of 5 rpm was used. Due to the target set-up two nanolayer periods are formed per revolution of the substrate table. In the equipment used 5 rpm table rotational speed was known to give an average nanolayer period thickness of about 4 nm for this particular nano-multilayer, which had also been confirmed by TEM analysis. Since each of the (Ti,AI)N and (Ti,Si)N sublayers has about the same thickness the average sublayer thickness for both sublayers was about 2 nm. TEM analysis can generally be used for determining the average sublayer thicknesses of a deposited nano-multilayer.

Then, an outermost layer of (Cr,AI)N was deposited on the nano-multilayer. Different outermost layers of (Cr,AI)N were deposited giving different samples 8 to 13. For each sample there were always targets of Ti_{0.40}Al_{0.60} and targets of Ti_{0.80}Si_{0.20} mounted but the Cr-Al targets mounted were different in order to obtain (Cr,AI)N outermost layers of different elemental compositions.

The target compositions of Cr-Al used for the respecive sample are seen in Table 3. The chamber pressure (reaction pressure) was set to 4 Pa, or set to 10 Pa, of N₂ gas and a desired DC bias voltage which for the samples were -70 V in combination with 4 Pa and -300 V in combination with 10 Pa, see Table 3. The cathodes were run in an arc discharge mode at a current of 150 A (each). A 0.5 µm layer of (Cr,AI)N was deposited. Thus, the two different process conditions used were identical to what were used for making the monolayers of (Cr,AI)N in Example 1. One can therefore conclude from the analysis made of the samples 1 to 6 of Example 1 which were (Cr,AI)N layers like the ones used now as outermost layers what properties in terms of elemental compositions and crystal structures the outermost (Cr,AI)N layers deposited on a combination of metal nitrides below had. The samples each having an inner combination of Ti_{0.40}Al_{0.60}N + nano-multilayer Ti_{0.40}Al_{0.60}N/Ti_{0.80}Si_{0.20}N with an outermost (Cr,AI)N layer are samples 8 to 13 seen in Table 3.

**Table 3.**

| Sample | Layer 1 +Layer 2 (metal nitride layers (M)) | Layer 3, outermost (Cr,AI)N layer | | | |
|---|---|---|---|---|---|
| | | Target | Process data | Elemental composition* | Crystal structure* |
| 8 | Ti_{0.40}Al_{0.60}N + nano-multilayer Ti_{0.40}Al_{0.60}N/Ti_{0.80}Si_{0.20}N | Cr30Al70 | 4 Pa, -70V | Cr31Al69N | single phase B1 cubic (XRD) |
| 9 | Ti_{0.40}Al_{0.60}N + nano-multilayer Ti_{0.40}Al_{0.60}N/Ti_{0.80}Si_{0.20}N | Cr25Al75 | 4 Pa, -70V | Cr23Al77N | cubic + hexagonal (XRD) |
| 10 | Ti_{0.40}Al_{0.60}N + nano-multilayer Ti_{0.40}Al_{0.60}N/Ti_{0.80}Si_{0.20}N | Cr25Al75 | 10 Pa, - 300V | Cr28Al72N | single phase B1 cubic (XRD) |
| 11 | Ti_{0.40}Al_{0.60}N + nano-multilayer Ti_{0.40}Al_{0.60}N/Ti_{0.80}Si_{0.20}N | Cr20Al80 | 4 Pa, -70V | Cr19AI81 N | single phase hexagonal (XRD) |
| 12 | Ti_{0.40}Al_{0.60}N + nano-multilayer Ti_{0.40}Al_{0.60}N/Ti_{0.80}Si_{0.20}N | Cr20Al80 | 10 Pa, - 300V | Cr22Al78N | single phase B1 cubic (XRD, TEM) |
| 13 | Ti_{0.40}Al_{0.60}N + nano-multilayer Ti_{0.40}Al_{0.60}N/Ti_{0.80}Si_{0.20}N | Cr15AI85 | 10 Pa, - 300V | Cr13AI87N | single phase B1 cubic (XRD) |

| | | | | | |
|---|---|---|---|---|---|
| * elemental composition based on EDX results for (Cr,Al)N layers of Example 1. | | | | | |

### Example 3 - Cutting tests

Cutting tests were made in order to determine the performance of the samples made.

### Explanations to terms used:

The following expressions/terms are commonly used in metal cutting, but nevertheless explained in the table below:

| | |
|---|---|
| Vc (m/min): | cutting speed in meters per minute |
| fz (mm/tooth): | 1 feed rate in millimeter per tooth (in milling) |
| z: (number) | number of teeth in the cutter |
| ae (mm): | radial depth of cut in millimeter |
| aₚ (mm): | axial depth of cut in millimeter |

### Thermal crack resistance test (TTT):

Shoulder milling
Tool holder: R390, Dc=25 mm
Work piece material: Toolox33 (tool steel), 600x200x100mm
Insert type: R390-11
z=1
V_{c}= 275 m/min
f_{z}=0.20 mm
aₑ=12.5 mm
aₚ=3.0 mm
With cutting fluid

The cut off criteria is reached when the cracks have resulted in chipping of the edge >0.30 mm. Tool life is presented as the number of cut entrances in order to achieve this criteria.
Edge line toughness (ELT):
Shoulder milling
Tool holder: R390, Dc=32 mm
Work piece material: Dievar steel
z=1
V_{c}=215 m/min
fz=0.15 mm
aₑ=12 mm
aₚ=3.0 mm
length of cut=12 mm
without cutting fluid

The cut-off criteria are chipping of at least 0.5 mm of the edge line. Tool life is presented as the number of cut entrances in order to achieve these criteria.

**Table 4.**

| Sample | Outermost (Cr,AI)N layer | Crystal structure | ELT | TTT |
|---|---|---|---|---|
| 8 (comparative) | Cr31AI69N | single phase B1 cubic (XRD) | 26 | 33 |
| 9 (comparative) | Cr23Al77N | cubic + hexagonal (XRD) | 44 | 30 |
| 10 (comparative) | Cr28Al72N | single phase B1 cubic (XRD) | 33 | 34 |
| 11 (comparative) | Cr19Al81N | single phase hexagonal (XRD) | 14 | 25 |
| 12 (invention) | Cr22Al78N | single phase B1 cubic (XRD, TEM) | 59 | 40 |
| 13 (comparative) | Cr13AI87N | single phase B1 cubic (XRD) | 29 | 30 |

A coated cutting tool within the present invention having a fully cubic outermost layer of Cr22Al78N (Sample 12) surprisingly outperformed all other samples. In order to provide the excellent result it is seen that the (Cr,AI)N must fulfil both a first criterion of having a comparatively high Al content within a quite narrow elemental content range, and a second criterion of being of a single phase B1 cubic structure.

## Claims

1. A coated cutting tool (1) comprising a substrate body (5) and a coating (6), the coating (6) comprises a sequence of layers, in the order from the substrate body (5) surface, being one or more metal nitride layer(s) (M)(7), the total thickness of the one or more metal nitride layer(s) (M) (7) is from 0.5 to 8 µm, followed by a layer of Cr₁₋ₓAlₓN (8), 0.75≤x≤0.85, as an uppermost layer having a thickness of from 0.1 to 2 µm, the layer of Cr₁₋ₓAlₓN (8) is of a single phase B1 cubic structure.

2. A coated cutting tool (1) according to claim 1, wherein in the layer of Cr₁₋ₓAlₓN (8), 0.755x50.82.

3. A coated cutting tool (1) according to any one of claims 1-2, wherein the layer of Cr₁₋ₓAlₓN (8), has a thickness of from 0.2 to 1 µm.

4. A coated cutting tool (1) according to any one of claims 1-2, wherein the total thickness of the one or more metal nitride layer(s) (M) (7) is from 1 to 6 µm.

5. A coated cutting tool (1) according to any one of claims 1-4, wherein any of the one or more metal nitride layer(s) (M) (7) is a monolithic layer.

6. A coated cutting tool (1) according to claim 5, wherein the monolithic layer(s) of the one or more metal nitride layer(s) (M) (7) belong(s) to the group of (Ti,AI)N, (Ti,Al,Si)N, (Ti,Si)N, (Ti,Al,Cr)N, (Ti,Al,Cr,Si)N, (Ti,Al,Si)N and (Ti,Al,Cr,Si)N.

7. A coated cutting tool (1) according to any one of claims 1-4, wherein any of the one or more metal nitride layer(s) (M) (7) is a nano-multilayer of at least two different sublayers of metal nitrides which are different in their elemental composition, the sublayers having each an average thickness of from 1 to 50 nm.

8. A coated cutting tool (1) according to claim 7, wherein the nano-multilayer(s) of the one or more metal nitride layer(s) (M) (7) belong(s) to the group of (Ti,AI)N, (Ti,Al,Si)N, (Ti,Si)N, (Ti,Al,Cr)N, (Ti,Al,Cr,Si)N, (Ti,Al,Si)N and (Ti,Al,Cr,Si)N.

9. A coated cutting tool (1) according to any one of claims 7-8, wherein the at least two different sublayers of metal nitrides in the nano-multilayer(s) belong to the group of (Ti,AI)N, (Ti,Al,Si)N, (Ti,Si)N, (Ti,Al,Cr)N, (Ti,Al,Si)N, (Ti,Al,Cr,Si)N and (AI,Cr)N.

10. A coated cutting tool according to any one of claims 7-9, wherein the one or more metal nitride layer(s) (M) (7) comprises a nano-multilayer which comprises sublayers of (Ti,AI)N and (Ti,Si)N.

11. A coated cutting tool (1) according to any one of claims 1-10, wherein the substrate body (5) is of a cemented carbide, a cermet, a cubic boron nitride, a ceramic, or a high-speed steel, preferably a cemented carbide.

12. A coated cutting tool (1) according to any one of claims 1-11, wherein the cutting tool (1) is a cutting insert for milling, a cutting insert for turning, a cutting insert for drilling, a drill or an endmill.

13. A method for producing a coated cutting tool (1), the coated cutting tool (1) comprises a substrate body (5) and a coating (6), the coating (6) comprises a sequence of layers, in the order from the substrate body (5) surface, being one or more metal nitride layer(s) (M)(7), the total thickness of the one or more metal nitride layer(s) (M) (7) is from 0.5 to 8 µm, followed by a layer of Cr₁₋ₓAlₓN (8), 0.75≤x≤0.85, as an uppermost layer having a thickness of from 0.1 to 2 µm, the layer of Cr₁₋ₓAlₓN (8) is of a single phase B1 cubic structure,
**characterised in that** the method comprises the following steps of:
- providing a PVD reaction chamber,
- mounting one or more targets for making the one or more metal nitride layers (M)(7), mounting one or more targets of a composition Cr_{1-y}Al_{y}, 0.78≤y≤0.85, and mounting cutting tool blanks in the PVD reaction chamber, then
- depositing the one or more metal nitride layers (M)(7) by cathodic arc evaporation, followed by
- depositing the layer of Cr₁₋ₓAlₓN (8) by cathodic arc evaporation in an N₂ atmosphere at a total pressure of from 7 to 15 Pa, a DC bias voltage of from -275 to -350 V and an evaporation current of from 75 to 200 A.

14. A method according to claim 13, wherein the deposition of the layer of Cr₁₋ₓAlₓN (8) is made at a total pressure of from 8 to 12 Pa, a DC bias voltage of from - 300 to -325 V and an evaporation current of from 100 to 175 A.

15. A method according to any one of claims 13-14, wherein the targets of CrAI is of a composition Cr_{1-y}Al_{y}, 0.80≤y≤0.85.
